(19) Europäisches Patentamt / European Patent Office / Office européen des brevets

(11) **EP 2 754 338 B1**

(12) **FASCICULE DE BREVET EUROPEEN**

(45) Date de publication et mention de la délivrance du brevet:
**19.08.2015  Bulletin 2015/34**

(21) Numéro de dépôt: **12756190.0**

(22) Date de dépôt: **06.09.2012**

(51) Int Cl.:
*H05K 1/16* *(2006.01)*   *H01F 17/00* *(2006.01)*
*H01F 27/28* *(2006.01)*   *H02K 3/26* *(2006.01)*
*H02K 3/28* *(2006.01)*   *G01R 19/00* *(2006.01)*
*G01R 33/00* *(2006.01)*   *G01R 33/04* *(2006.01)*
*G01R 33/05* *(2006.01)*   *G01R 15/18* *(2006.01)*
*H01F 38/30* *(2006.01)*   *H05K 1/02* *(2006.01)*
*H05K 3/46* *(2006.01)*

(86) Numéro de dépôt international:
**PCT/EP2012/067455**

(87) Numéro de publication internationale:
**WO 2013/034661 (14.03.2013 Gazette 2013/11)**

(54) **CAPTEUR DE COURANT ET CIRCUIT IMPRIMÉ POUR CE CAPTEUR**

STROMSENSOR UND LEITERPLATTE FÜR DIESEN SENSOR

CURRENT SENSOR AND PRINTED CIRCUIT BOARD FOR THIS SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **07.09.2011  FR 1157938**

(43) Date de publication de la demande:
**16.07.2014  Bulletin 2014/29**

(73) Titulaire: **Commissariat à l'Énergie Atomique et aux Énergies Alternatives**
**75015 Paris (FR)**

(72) Inventeur: **KLEIN, Philippe**
**F-38830 Saint Pierre d'Allevard (FR)**

(74) Mandataire: **GIE Innovation Competence Group**
**310 bis, Avenue Berthelot**
**69008 Lyon (FR)**

(56) Documents cités:
EP-A1- 2 108 965       WO-A2-02/25797
DE-A1- 10 354 694      US-A1- 2002 070 831
US-A1- 2003 011 458    US-A1- 2011 108 317

**Description**

L'invention concerne un capteur de courant et un circuit imprimé pour ce capteur de courant.

Un circuit imprimé, également plus connu sous l'acronyme PCB (Printed Circuit Board), est un support permettant de relier électriquement un ensemble de composants électriques. Un tel circuit imprimé se présente généralement sous la forme d'une plaque stratifiée. Ce circuit imprimé peut être monocouche ou multicouche. Un circuit imprimé monocouche ne comporte qu'une seule couche de métallisation dans laquelle sont imprimées des pistes conductrices qui raccordent électriquement les différents composants électriques entre eux. Un circuit imprimé multicouche comporte, au contraire, plusieurs couches de métallisation c'est-à-dire au moins deux couches et, de préférence, plus de quatre ou six couches. Dans la suite de cette description, on s'intéresse principalement à ces circuits imprimés multicouches.

Une couche de métallisation est l'une des couches de la plaque stratifiée formant le circuit imprimé dans laquelle sont réalisées une ou plusieurs pistes conductrices qui raccordent électriquement les différents composants électriques entre eux. Cette couche est plane et s'étend parallèlement au plan de la plaque stratifiée. Généralement, la couche de métallisation est obtenue en déposant une couche uniforme d'un matériau conducteur, typiquement un métal tel que du cuivre, puis en gravant cette couche uniforme pour ne laisser subsister que les pistes conductrices.

Les différentes couches de métallisation du circuit imprimé sont espacées mécaniquement les unes des autres par des couches isolantes en matériau électriquement isolant. Ce matériau isolant présente une rigidité diélectrique élevée c'est-à-dire typiquement supérieure à 3 MV/m et, de préférence, supérieure à 10 MV/m. Par exemple, le matériau électriquement isolant est réalisé à partir de résine époxyde et/ou de fibre de verre. La couche isolante se présente généralement sous la forme d'une plaque rigide réalisée dans un matériau qui ne devient pas visqueux lors de son assemblage avec d'autres couches. Par exemple, elle est réalisée à partir d'une résine thermodurcissable qui a déjà subi un thermodurcissement irréversible.

Les différentes couches du circuit imprimé multicouche sont assemblées les unes aux autres, sans aucun degré de liberté, à l'aide de couches adhésives appelées « pré-imprégné » et plus connues sous le terme anglais de « prepreg ».

Un pré-imprégné est constitué d'une résine thermodurcissable imprégnant, généralement, un renfort tel qu'un tissu. Typiquement, la résine est une résine époxyde. Lors de la fabrication du circuit imprimé, la transformation de la résine thermodurcissable fait intervenir une polymérisation irréversible qui transforme le pré-imprégné en un matériau solide et rigide qui colle entre elles de façon irréversible les différentes couches du circuit imprimé. Typiquement, chaque transformation intervient lorsque le pré-imprégné est chauffé à une température élevée et est comprimé avec une pression élevée. Ici, une température élevée est une température supérieure à 100°C et, de préférence supérieure à 150°C. Une pression élevée est une pression supérieure à 0,3 MPa et, typiquement, supérieure à 1 MPa.

Les pistes conductrices des différentes couches de métallisation peuvent être électriquement raccordées par l'intermédiaire de plots conducteurs traversant les couches isolantes. Les plots conducteurs sont plus connus sous le terme de « vias ». Les vias s'étendent généralement perpendiculaires au plan des couches. Il existe différentes façons de fabriquer ces vias. L'une des plus communes consiste à réaliser un trou dans la ou les couches isolantes à traverser puis à recouvrir d'un métal la paroi intérieure de ces trous. On parle alors de trous métallisés.

Un via ne traverse pas nécessairement toutes les couches du circuit imprimé. Ainsi, il existe des vias borgnes qui débouchent sur une seule face extérieure du circuit imprimé. Aujourd'hui, il est également possible de réaliser des vias « enterrés », par exemple, à l'aide de technologies connues telles que la technologie connue sous l'acronyme de HDI (« High Density of Intégration »). Un via enterré ne débouche sur aucune des faces extérieures du circuit imprimé. Par exemple, un via enterré permet de raccorder électriquement des pistes conductrices réalisées dans des couches de métallisation enfouies à l'intérieur du circuit imprimé.

Des capteurs de courant connus comportent :

- un circuit imprimé comprenant :

  • un empilement, le long d'une direction verticale, de plusieurs couches de métallisation séparées mécaniquement les unes des autres par des couches électriquement isolantes,
  • un noyau magnétique,
  • une ou plusieurs premières bobines remplissant les fonctions de bobine de mesure et de bobine d'excitation, chaque première bobine étant pourvue de spires uniquement enroulées autour du noyau magnétique, et

- une source de courant d'excitation propre à faire circuler dans la bobine d'excitation un courant dont l'intensité provoque une saturation périodique du noyau magnétique.

Un capteur de courant connu est par exemple divulgué dans l'article suivant : T. O'DONNELL, A. TIPEK, A. CONNELL, P. Mc CLOSKEY, S. C. O'MATHUNA, « Planar fluxgate current sensor integrated in printed circuit board », Sensors and Actuators A 129 (2006) 20-24.

Ce capteur de courant fonctionne bien. Par exemple, le fait de saturer périodiquement le noyau magnétique permet de mesurer la contribution du champ

magnétique $B_i$ généré par le courant à mesurer à des fréquences élevées et accroît la dynamique du capteur. Par fréquence élevée, on désigne une fréquence supérieure à 100Hz et, de préférence, supérieure à 1 kHz. Cette technique de mesure est connue sous le terme de capteur à vanne de flux et plus connue sous le terme anglais de « fluxgate ». Toutefois, pour que ce capteur fonctionne bien, il faut être capable de compenser précisément la contribution du champ magnétique d'excitation $B_{ex}$ généré à l'intérieur du noyau par la bobine d'excitation. Pour cela, le fil conducteur doit être positionné précisément par rapport au noyau magnétique. Ce problème a été résolu dans les capteurs connus en réalisant une piste conductrice dans le circuit imprimé dans laquelle le courant à mesurer circule. En effet, avec les technologies actuelles, il est possible de positionner très précisément une piste conductrice d'un circuit imprimé. Toutefois, lors de l'utilisation de ce capteur, il est nécessaire de raccorder le fil conducteur à cette piste conductrice du circuit imprimé. Cela suppose de prévoir des bornes de connexion sur le circuit imprimé, ce qui accroît l'encombrement du capteur de courant. Cela impose aussi de couper systématiquement le fil conducteur dans lequel circule le courant à mesurer ce qui n'est pas toujours souhaitable.

De l'état de la technique est également connu de :

- EP2108965A1,
- US2003/011458A1,
- DE10354694A1,
- US2011/108317A1,
- US2002/070831A1,
- WO02/25797A2.

L'invention vise à remédier à au moins l'un de ces inconvénients. Elle a donc pour objet un capteur de courant dans lequel :

- le circuit imprimé comporte un trou le traversant de part en part le long d'un axe vertical pour recevoir le fil conducteur,
- le noyau magnétique forme un premier anneau magnétique entourant le trou et s'étendant horizontalement entre des couches de métallisation, et
- chaque spire de chaque première bobine est formée par deux pistes conductrices réalisées, respectivement, dans des couches de métallisation situées au-dessus et en-dessous du premier anneau magnétique et raccordées électriquement l'une à l'autre par un via passant par le centre de cet anneau magnétique.

Dans le capteur ci-dessus, le fil dans lequel le courant circule n'a pas besoin d'être raccordé à une piste conductrice du circuit imprimé. Il suffit simplement qu'il traverse le trou pour que le capteur puisse fonctionner.

De plus, le fait que l'anneau magnétique entoure le trou permet de rendre ce capteur beaucoup plus insensible aux erreurs de positionnement du fil conducteur dans ce trou. En effet, l'anneau magnétique canalise le champ magnétique généré par le courant à l'intérieur de l'anneau magnétique. Ainsi, il n'est pas nécessaire que le fil soit aussi précisément positionné à l'intérieur du trou.

Les bobines sont formées par des pistes conductrices réalisées dans les couches de métallisation et par des vias, ce qui facilite la fabrication de ce capteur.

Enfin, ce capteur fonctionne toujours selon le principe d'un « fluxgate » ce qui permet de conserver, voire d'améliorer, sa précision.

L'invention a également pour objet un circuit imprimé pour la réalisation du capteur ci-dessus.

Les modes de réalisation de ce capteur ou de ce circuit imprimé peuvent comporter une ou plusieurs des caractéristiques suivantes :

- le circuit imprimé comprend :

  - une cavité annulaire à l'intérieur de laquelle est logé l'anneau magnétique, et
  - les dimensions transversales, c'est-à-dire dans un plan vertical, de l'anneau magnétique sont inférieures d'au moins 5 $\mu$m aux dimensions transversales correspondantes de la cavité de manière à ménager un jeu entre les parois de cette cavité et les faces en vis-à-vis de l'anneau magnétique ;

- le capteur ou le circuit comporte :

  - au moins un second anneau magnétique entourant le même trou et s'étendant horizontalement entre des couches de métallisation,
  - une ou plusieurs secondes bobines remplissant les fonctions de bobine de mesure et de bobine d'excitation, chaque seconde bobine étant pourvue de spires uniquement enroulées autour du second anneau magnétique, chaque spire de chaque seconde bobine étant formée par deux pistes conductrices réalisées, respectivement, dans les couches de métallisation situées au-dessus et en-dessous du second anneau magnétique et raccordées électriquement l'une à l'autre par un plot traversant une couche isolante et passant par l'intérieur de ce second anneau magnétique, et
  - les première et seconde bobines de mesure sont raccordées en série de manière à diminuer la contribution du champ magnétique d'excitation dans le courant généré par ces bobines de mesure ;

- la première et la seconde bobines d'excitation sont agencées de manière à générer un champ magnétique d'excitation à l'intérieur, respectivement, des premier et second anneaux magnétiques de même intensité lorsqu'elles sont alimentées par le même courant d'excitation, et les première et seconde bobines de mesure sont agencées de manière à mesurer le même champ magnétique, respectivement, dans les premier et second anneaux en absence de champ magnétique d'excitation ;

■ les première et seconde bobines d'excitation sont identiques et les première et seconde bobines de mesure sont identiques sauf qu'elles sont enroulées, respectivement, autour des premier et second anneaux magnétiques.

Ces modes de réalisation présentent en outre les avantages suivants :

- le fait qu'il existe un jeu entre l'anneau magnétique et les parois de la cavité permet d'accroître la précision du capteur car l'anneau magnétique n'est alors pas contraint mécaniquement par le circuit imprimé ;
- utiliser deux anneaux magnétiques et raccorder les bobines de mesure en série permet de compenser facilement le champ magnétique d'excitation;
- agencer les bobines d'excitation pour qu'elles génèrent des champs magnétiques d'excitation de même intensité et de direction opposée facilite la compensation de ces champs dans la mesure ;
- des bobines d'excitation et de mesure identiques facilitent la réalisation du capteur.

L'invention sera mieux comprise à la lecture de la description qui va suivre, donnée uniquement à titre d'exemple non limitatif et faite en se référant aux dessins sur lesquels :

- la figure 1 est une illustration schématique, en coupe et en perspective, d'un capteur de courant ;
- la figure 2 est une illustration schématique, en coupe et en perspective, d'un circuit imprimé utilisé pour réaliser le capteur de la figure 1 ;
- la figure 2A est une illustration schématique de l'agrandissement d'un détail de la figure 2 ;
- la figure 3 est une illustration schématique, en coupe et en vue éclatée, d'un premier mode de réalisation du circuit imprimé de la figure 2 ;
- la figure 4 est une illustration schématique en coupe du circuit imprimé de la figure 2 ;
- la figure 5 est un organigramme d'un procédé de fabrication du circuit imprimé de la figure 2 ;
- la figure 6 est une illustration schématique, en coupe et en vue éclatée, d'un deuxième mode de réalisation du circuit imprimé de la figure 2 ;
- les figures 7 à 9 sont des illustrations schématiques en coupe d'un troisième mode de réalisation du circuit imprimé de la figure 2 ;
- la figure 10 est une illustration schématique, en coupe et en vue éclatée, d'un quatrième mode de réalisation du circuit imprimé de la figure 2 ;

- la figure 11 est une illustration schématique, en coupe et en vue éclatée, d'un cinquième mode de réalisation du circuit imprimé de la figure 2 ;
- la figure 12 est une illustration schématique en coupe d'un sixième mode de réalisation du circuit imprimé de la figure 2 ;
- les figures 13 et 14 sont des illustrations schématiques, en coupe et en vue éclatée, respectivement, d'un septième et d'un huitième mode de réalisation du circuit imprimé de la figure 2 ;
- la figure 15 est une illustration schématique, en coupe et en vue éclatée, d'un neuvième mode de réalisation du circuit imprimé de la figure 2 ;
- la figure 16 est une illustration schématique en perspective d'un pré-imprégné utilisé dans le mode de réalisation de la figure 15 ;
- la figure 17 est une illustration schématique, en coupe et en perspective, d'un autre mode de réalisation du circuit imprimé du capteur de la figure 1 ;
- la figure 18 est un organigramme d'un procédé de fabrication du circuit imprimé de la figure 17 ;
- les figures 19 à 21 sont des illustrations schématiques de différentes étapes de fabrication du procédé de la figure 18, et
- la figure 22 est une illustration schématique en perspective d'un capteur triaxial de champ magnétique.

Dans ces figures, les mêmes références sont utilisées pour désigner les mêmes éléments.

Dans la suite de cette description, les caractéristiques et fonctions bien connues de l'homme du métier ne sont pas décrites en détail.

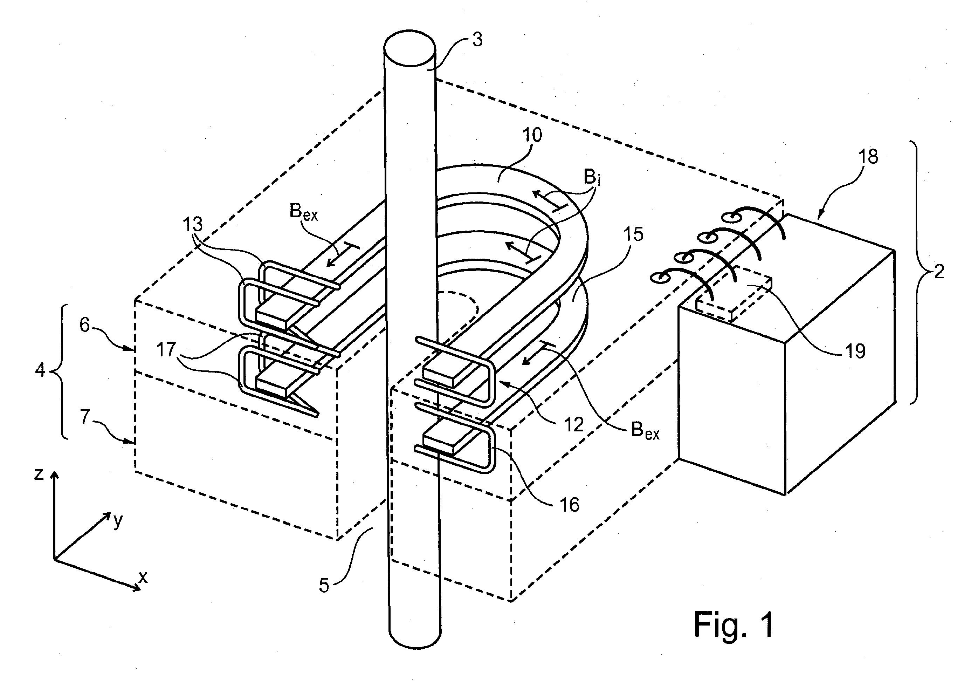

La figure 1 représente un capteur 2 de courant apte à mesurer l'intensité du courant circulant dans un fil conducteur 3.

Le capteur 2 comprend une superposition 4 de plusieurs circuits imprimés dans laquelle est ménagé un trou 5 traversant de part en part cette superposition 4 dans une direction verticale Z.

Le fil 3 est reçu dans le trou 5. A cet effet, les dimensions transversales du trou 5, c'est-à-dire dans un plan horizontal, sont typiquement plus grandes d'au moins 100 $\mu$m au diamètre extérieur du fil 3.

Ici, la superposition 4 est formée d'un empilement, dans la direction Z, de deux circuits imprimés 6 et 7. Ces circuits imprimés sont fixés l'un au-dessus de l'autre sans aucun degré de liberté. Le contour de ces circuits est représenté en pointillés pour laisser apparaître les différents éléments qui les composent.

Le circuit 6 comprend un empilement, le long de la direction Z, de plusieurs couches de métallisation séparées mécaniquement les unes des autres par des couches isolantes. Les différentes couches de ce circuit 6 s'étendent horizontalement parallèlement à des directions X et Y orthogonales.

Le circuit 6 comprend un noyau magnétique qui entoure le trou 5. Ce noyau est un anneau magnétique 10 qui s'étend essentiellement dans un plan horizontal.

Pour accroître la sensibilité du capteur 2, l'anneau magnétique 10 est réalisé dans un matériau magnétique présentant une perméabilité relative statique, c'est-à-dire pour une fréquence nulle, supérieure à 1 000 et, de préférence, supérieure à 10 000. Pour cela, il est réalisé dans un matériau magnétique présentant naturellement une forte perméabilité relative. Par exemple, il s'agit d'un matériau ferromagnétique tel qu'un mu-métal ou un matériau magnétique connu sous le nom commercial de Vitrovac® 6025.

De préférence, le centre de l'anneau 10 est centré sur le trou 5.

Une bobine d'excitation 12 destinée à être parcourue par un courant d'excitation $i_{ex}$ à une fréquence $f_{ex}$ est enroulée autour de l'anneau 10. Cette bobine 12 génère à l'intérieur de l'anneau 10 un champ magnétique d'excitation $B_{ex}$ qui sature périodiquement cet anneau.

De préférence, la bobine 12 s'étend sur toute la longueur de l'anneau 10. Par longueur de l'anneau 10, on désigne ici le périmètre de l'anneau magnétique dans le plan horizontal. Chaque spire de cette bobine traverse l'intérieur de l'anneau. Pour simplifier la figure 1, seule une spire de la bobine 12 a été représentée.

Le circuit imprimé 6 comprend aussi une bobine de mesure 13 destinée à mesurer l'intensité du champ magnétique à l'intérieur de l'anneau 10. Cette bobine 13 est entourée autour de la bobine 12 d'excitation. Pour simplifier la figure 1, seules deux spires de cette bobine 13 ont été représentées. Chaque spire traverse le centre de l'anneau 10. Cette bobine 13 s'étend sur toute la longueur de l'anneau magnétique 10. Dans la suite de cette description, la mesure de cette bobine 13 est donnée par la relation suivante : $M_1 = B_i + B_{ex}$, où :

- $M_1$ est la mesure de la bobine 13,
- $B_i$ est le champ magnétique généré par le courant i qui circule dans le fil 3, et
- $B_{ex}$ est le champ magnétique d'excitation.

Pour écrire cette formule, on suppose que le signe du champ magnétique est positif quand ce champ magnétique tourne à l'intérieur de l'anneau 10 dans le sens antihoraire.

L'utilisation d'un anneau magnétique permet de compenser automatiquement l'influence de champ magnétique extérieur homogène sur toute la surface du circuit imprimé 6. Par « compenser », on désigne l'action d'éliminer ou de réduire fortement la contribution d'un champ magnétique dans la mesure de l'intensité du courant i. Par exemple, cela permet de compenser automatiquement l'influence du champ magnétique terrestre.

Le circuit imprimé 7 est le symétrique du circuit imprimé 6 par rapport à un plan horizontal sauf que la bobine d'excitation est ici enroulée en sens inverse. L'anneau magnétique, la bobine d'excitation et la bobine de mesure du circuit imprimé 7 portent, respectivement, les références 15, 16 et 17. La bobine 16 est alimentée par le même courant d'excitation $i_{ex}$ que la bobine d'excitation 12. Dans ces conditions, la mesure de la bobine 17 est donnée par la relation suivante : $M_2 = B_i - B_{ex}$, où $M_2$ est la mesure de la bobine 17.

Ici, les bobines 13 et 17 sont raccordées en série pour compenser automatiquement la contribution du champ magnétique d'excitation $B_{ex}$. Par « compenser », on désigne le fait d'éliminer au mieux l'influence ou la contribution de ce champ magnétique $B_{ex}$ dans le résultat final, c'est-à-dire ici dans la mesure du courant. Avec les conventions de signe adoptées ici, les bobines 13 et 17 sont raccordées de manière à additionner les mesures $M_1$ et $M_2$.

Le capteur 2 comprend également une unité électronique 18 de traitement raccordée à la superposition 4 par l'intermédiaire de liaisons filaires. Cette unité 18 traite les mesures obtenues à partir des bobines 13 et 17 pour obtenir une mesure de l'intensité du courant i qui circule dans le fil 3. L'unité 18 comporte aussi une source 19 de courant apte à générer le courant d'excitation $i_{ex}$ qui circule dans les bobines 12 et 16.

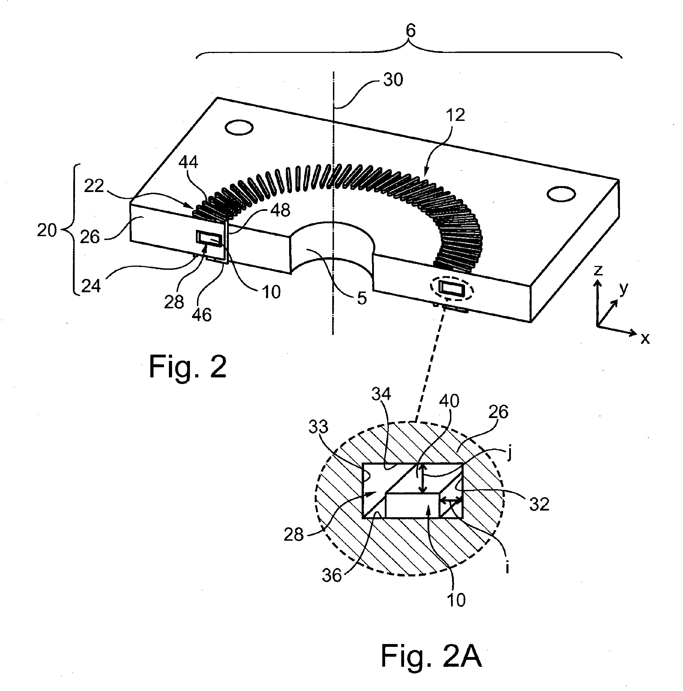

La figure 2 représente plus en détail le circuit imprimé 6 utilisé pour réaliser le capteur 2. La figure 2 représente une coupe du circuit imprimé 6 pour faire apparaître les détails qui sont enfouis à l'intérieur de ce circuit imprimé.

Le circuit imprimé 6 est un circuit imprimé multicouche. Il est donc formé d'un empilement 20, le long de la direction verticale Z de plusieurs couches de métallisation séparées par des couches isolantes. Dans la figure 2, seules deux couches de métallisation 22 et 24 séparées par une couche isolante 26 sont représentées. Cet empilement 20 est décrit plus en détail en regard des figures suivantes.

Une cavité 28 est creusée dans la couche isolante 26 pour recevoir l'anneau magnétique 10. La cavité 28 et ses détails sont plus visibles sur la portion agrandie de la coupe du circuit imprimé représentée dans la figure 2A. Ici, la cavité 28 est annulaire. Elle est située entre les deux couches de métallisation 22 et 24. Cette cavité admet un axe 30 de symétrie verticale. L'axe 30 est également un axe de symétrie pour le trou 5. Cette cavité présente une section transversale rectangulaire. Une section transversale est la section contenue dans un plan vertical contenant l'axe 30. Plus précisément, la cavité 28 présente une paroi verticale extérieure 32, une paroi verticale intérieure 33, un toit plat 34 et un fond plat 36. Les parois verticales 32 et 33 sont circulaires. La section transversale de la cavité est constante sur toute sa longueur. La longueur de la cavité est son périmètre, par exemple intérieur, dans un plan horizontal.

L'anneau magnétique 10 est logé à l'intérieur de la cavité 28. L'axe de révolution de l'anneau 10 est confondu avec l'axe 30. La section transversale de l'anneau magnétique 10 est également rectangulaire. Cette section transversale est également constante sur toute la longueur de l'anneau 10.

De manière à accroître la perméabilité relative statique, l'épaisseur e dans la direction Z du noyau est la plus réduite possible. Par exemple, le noyau a une épaisseur typiquement inférieure à 250 μm et de préférence inférieure à 125 μm ou 25μm. Sa largeur $l$ dans une direction radiale est typiquement comprise entre 0,5 mm et 10 mm. Par exemple, ici, la largeur $l$ est comprise entre 1 et 2 mm.

Cet anneau magnétique 10 présente une face inférieure qui repose sur le fond 36 de la cavité 28, par exemple uniquement sous l'action de la force de gravité. L'anneau 10 présente également une face supérieure 40 en vis-à-vis du toit 34 de la cavité 28 et des faces verticales extérieure et intérieure en vis-à-vis, respectivement, des parois verticales 32 et 33.

Les dimensions de la section transversale de l'anneau 10 sont inférieures aux dimensions correspondantes de la section transversale de la cavité 28. Ainsi, sa largeur $l$ et son épaisseur $e$ sont inférieures, respectivement, à la largeur et à l'épaisseur de la cavité 28. Ceci permet de séparer l'anneau 10 des parois verticales 32 et 33 par un jeu latéral $i$ et de séparer la face supérieure 40 de l'anneau 10 du toit 34 par un jeu $j$. Les jeux $i$ et $j$ sont supérieurs à 5 μm et, de préférence, supérieurs à 100 μm. Ainsi, dans ces conditions, la cavité 28 n'exerce aucune contrainte mécanique sur l'anneau 10. Le fait que l'anneau 10 ne soit pas contraint mécaniquement accroît la précision du capteur 2 car cela limite les modifications de ses propriétés magnétiques.

Le circuit 6 comprend également les bobines 12 et 13. Pour simplifier la représentation, seules les spires de la bobine 12 sont représentées. Par exemple, ces spires sont régulièrement disposées à intervalles réguliers sur toute la longueur de l'anneau 10.

Chaque spire de la bobine 12 est formée par :

- une piste conductrice 44 réalisée dans la couche de métallisation 22, et
- une piste conductrice 46 réalisée dans la couche de métallisation 24.

Chaque spire comprend également un via vertical 48 reliant électriquement des extrémités des pistes 44 et 46 d'une même spire. L'autre extrémité des pistes conductrices est également raccordée par un autre via vertical à l'extrémité d'une piste conductrice d'une spire adjacente.

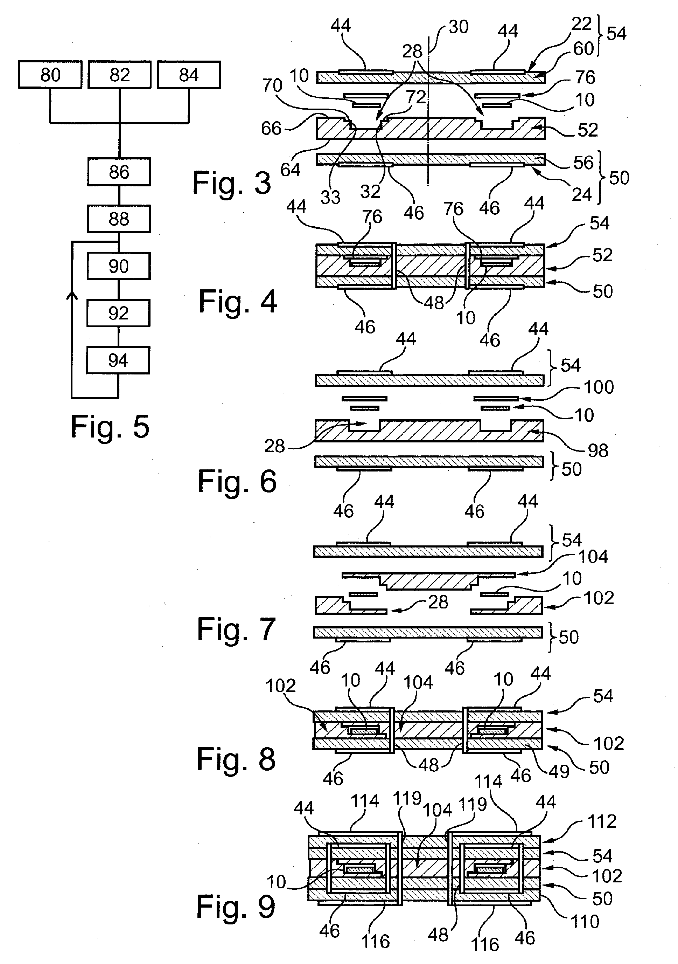

La figure 3 représente un premier mode de réalisation du circuit imprimé 6 en vue explosée. Sur ce mode de réalisation, l'empilement 20 est réalisé en empilant du bas vers le haut :

- un pré-imprégné métallisé 50,
- une couche isolante 52, et
- un pré-imprégné métallisé 54.

Le pré-imprégné métallisé 50 comprend un pré-imprégné 56 et la couche de métallisation 24 fixée sur la face inférieure du pré-imprégné 56.

Le pré-imprégné métallisé 54 comprend un pré-imprégné 60 et la couche de métallisation 22 fixée sur une face supérieure du pré-imprégné 60.

Ici, les pré-imprégnés 56 et 60 sont des pré-imprégnés qualifiés de « standard » c'est-à-dire présentant une viscosité faible lors de l'assemblage du circuit imprimé. Par viscosité faible, on désigne une viscosité inférieure à 5000 Pa.s et, de préférence, inférieure à 1000 Pa.s à la température de transition vitreuse lorsque la température du pré-imprégné est élevée conformément aux spécifications du fabricant de ce pré-imprégné.

Par exemple, les pré-imprégnés 56 et 60 peuvent être réalisés dans l'un des matériaux suivants : FR-2 (Papier Coton Phenolic), FR-3 (Résine epoxyde, papier et coton), FR-4 (Fibre de verre tissée et résine époxyde), FR-5 (Fibre de verre tissée et résine époxyde), FR-6 (Couchage de verre et polyester), G-10 (Fibre de verre tissée et résine époxyde), CEM-1 (papier coton et résine époxyde), CEM-2 (papier coton et résine époxyde), CEM-3 (Fibre de verre tissée et résine époxyde), CEM-4 (Fibre de verre tissée et résine époxyde), CEM-5 (Fibre de verre tissée et polyester). Ici, ces pré-imprégnés 56 et 60 sont des pré-imprégnés de la famille de produits sous la référence 33N (par exemple, le pré-imprégné de référence 33N2355) vendu par la société Arlon®.

La couche 52 est une couche isolante telle que celle décrite dans l'introduction de cette demande de brevet. Par exemple, cette couche 52 est conforme au standard FR-4. Elle présente une face inférieure 64 en vis-à-vis du pré-imprégné 56 et une face supérieure 66 tournée vers le pré-imprégné 60. Les pré-imprégnés 56 et 60 recouvrent entièrement, respectivement, les faces 64 et 66. Ils sont également directement déposés sur ces faces 64 et 66, c'est-à-dire en contact direct sans passer par l'intermédiaire d'autres couches.

La cavité 28 est creusée à partir de la face 66 à l'intérieur de la couche 52. Cette cavité 28 présente donc une bouche qui débouche dans la face 66. Cette bouche forme deux épaulements 70 et 72, respectivement, en haut des parois verticales 32 et 33 de la cavité 28. La profondeur de ces épaulements 70 et 72 est donnée par la relation suivante : p = h - e - j, où :

- p est la profondeur des épaulements 70, 72,
- h est la profondeur de la cavité 28,
- e est l'épaisseur de l'anneau 10, et
- j est le jeu vertical entre l'anneau 10 et le toit 34 de la cavité 28.

Les profondeurs p et h sont mesurées selon la direction Z.

Le circuit imprimé 6 comporte également un capot 76 formant des moyens anti-fluage propres à empêcher l'écoulement du pré-imprégné 60, par fluage lors de l'assemblage, sur l'anneau magnétique 10. A cet effet, le capot 76 a ici la forme d'un anneau circulaire dans l'axe de révolution est confondu avec l'axe 30. Le diamètre intérieur et le diamètre extérieur de ce capot 76 sont choisis pour qu'ils reposent, respectivement, sur les épaulements 72 et 70. Ainsi, ce capot 76 ne vient pas en appui sur l'anneau magnétique 10 lorsque le circuit imprimé est assemblé et n'exerce donc aucune contrainte mécanique sur cet anneau magnétique 10.

L'épaisseur du capot 76 est inférieure ou égale à la profondeur p des épaulements 70 et 72. Par exemple, l'épaisseur du capot 76 est inférieure à la profondeur d'au plus 10 %. Ainsi, après assemblage, le capot ne forme pas une saillie au-delà de la face supérieure 66.

Le capot 76 est réalisé dans un matériau rigide c'est-à-dire un matériau dont le module de Young est supérieur à 2 GPa et de préférence supérieur à 10 ou 100 Gpa. Dans cette description, les modules de Young sont donnés à une température de 20°C. Par exemple, il est réalisé en FR-4. Par exemple, il est réalisé par découpage d'une plaque rigide. Le capot est réalisé dans un matériau non magnétique, c'est-à-dire dont la perméabilité relative statique est égale à un.

La figure 4 représente le même circuit imprimé que la figure 3 mais dans une position assemblée. De plus, sur la figure 4, les vias verticaux 48 qui relient les pistes 44 aux pistes 46 ont été représentés. Une fois assemblée, la superposition de la couche 52 et des pré-imprégnés 56 et 60 forme la couche isolante 26.

Un procédé de fabrication du circuit imprimé 6 va maintenant être décrit en référence au procédé de la figure 5.

Lors d'une étape 80, la couche 52 est usinée pour former la cavité 28.

En parallèle, lors d'une étape 82, l'anneau magnétique 10 est fabriqué indépendamment de la fabrication de la couche 52. Par exemple l'anneau magnétique 10 est fabriqué par découpage d'une feuille en matériau magnétique.

En parallèle de l'étape 82, lors d'une étape 84, le capot 76 est également fabriqué indépendamment de la fabrication de l'anneau 10 et de la couche 52. Par exemple le capot 76 est fabriqué par découpage d'un panneau d'un matériau non magnétique rigide.

Ensuite, lors d'une étape 86, l'anneau magnétique 10 est inséré dans la cavité 28.

Lors d'une étape 88, le capot 76 est déposé sur les épaulements 70 et 72 de la cavité 28.

Lors d'une étape 90, on procède à l'assemblage des couches de métallisation. A cet effet, dans ce mode de réalisation, les pré-imprégnés métallisés 50 et 54 sont disposés, respectivement, en vis-à-vis des faces 64 et 66 de la couche isolante 52. Ensuite, les pré-imprégnés sont chauffés à une température supérieure ou égale à 150°C et, dans le même temps, une pression verticale supérieure à 1 MPa est appliquée à l'assemblage des couches pour provoquer le thermodurcissement des pré-imprégnés 56 et 60. Lors de cette étape, les pré-imprégnés 56 et 60 se transforment par polymérisation en un matériau rigide qui colle définitivement les couches de métallisation aux faces 64 et 66 de la couche isolante 52.

Lors de l'étape 90, le pré-imprégné 60 flue. Toutefois, le capot 76 empêche que le pré-imprégné ne s'écoule jusqu'à l'anneau magnétique 10 pour former un composite à dilatation thermique anisotrope.

Lors d'une étape 92, les pistes conductrices 44 et 46 sont réalisées dans les couches de métallisation, respectivement, 22 et 24. Par exemple, ces pistes sont réalisées par gravure des couches de métallisation.

Ensuite, lors d'une étape 94, les vias sont réalisés pour connecter électriquement les différentes pistes conductrices et ainsi former la bobine 12. Par exemple les vias sont réalisés par perçage puis métallisation des parois intérieures des trous ainsi réalisés.

Les étapes 90 à 94 peuvent être réitérées pour ajouter des couches de métallisation supplémentaire dans l'empilement.

La figure 6 représente un autre mode de réalisation du circuit imprimé 6 dans lequel les épaulements 70 et 72 sont omis. Dans ces conditions, le capot 76 est remplacé par un capot 100 dont les dimensions sont ajustées pour que celui-ci puisse être logé à l'intérieur de la cavité 28. Dans ce mode de réalisation, le capot 100 vient en appui mécanique sur l'anneau 10 mais ne forme pas un composite à dilatation thermique anisotrope avec l'anneau.

La figure 7 représente un autre mode de réalisation du circuit imprimé 6 en vue éclatée. Ce mode de réalisation est identique à celui décrit en référence à la figure 3 sauf que la couche isolante 52 est remplacée par une couche isolante 102 et le capot 76 est remplacé par un capot 104.

La couche isolante 102 est identique à la couche isolante 52 sauf que le noyau central de la couche 52 autour duquel s'entoure la cavité 28 est remplacé par un alésage qui traverse de part en part, verticalement, la couche isolante 102.

Le capot 104 est identique au capot 76 sauf que le noyau central qui a été supprimé de la couche isolante 102 est maintenant incorporé au capot 104. Le capot 104 a donc la forme d'un disque dont le noyau central est agencé pour être introduit dans l'alésage de la couche isolante 102.

La figure 8 représente le mode de réalisation de la figure 7 en position assemblée.

La figure 9 représente le circuit imprimé de la figure 8 après qu'on ait empilé sur les faces extérieures, supérieure et inférieure, de ce circuit imprimé des nouveaux pré-imprégnés métallisés, respectivement, 110 et 112. Ceci permet donc de rajouter deux couches de métallisation. Ici ces couches de métallisation supplémentaires sont utilisées pour former des pistes conductrices 114 et 116 reliées par des vias verticaux 119 pour former, par exemple, les spires de la bobine de mesure 13.

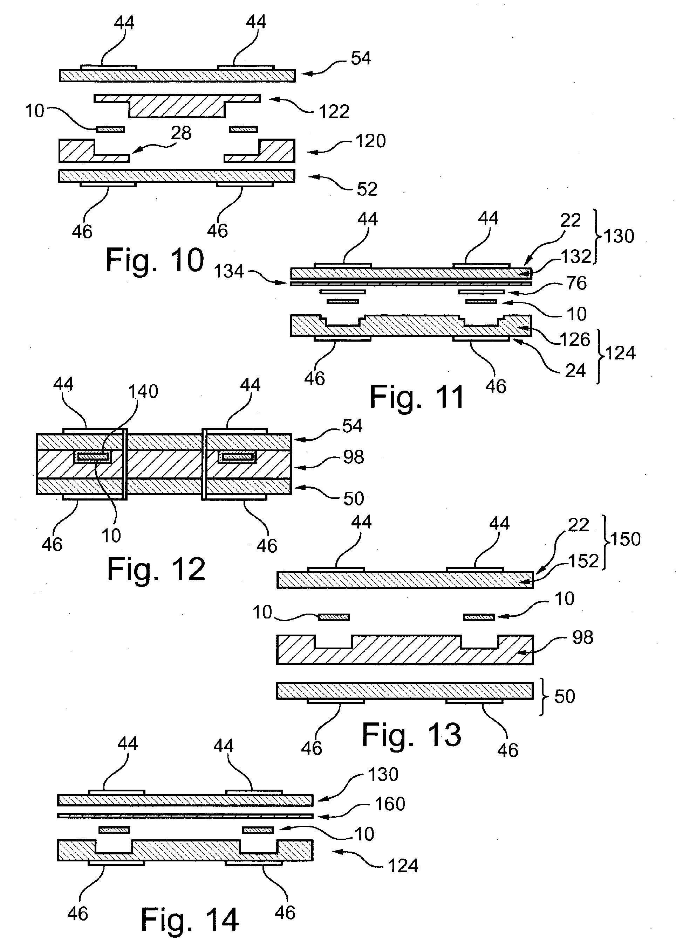

La figure 10 représente un autre mode de réalisation du circuit imprimé identique au mode de réalisation de la figure 7 sauf que les épaulements de la cavité 28 sont omis. Sur cette figure, la couche isolante et le capot portent, respectivement, les références 120 et 122.

La figure 11 représente un autre mode du circuit imprimé 6 identique à celui décrit au regard de la figure 3 sauf qu'il n'utilise pas de pré-imprégné métallisé mais des couches isolantes métallisées. Plus précisément, le pré-imprégné métallisé 50 et la couche isolante 52 sont remplacés par une couche isolante métallisée 124. La couche isolante métallisée 124 comprend une couche isolante 126 sur la face inférieure de laquelle est fixée la couche de métallisation 24. Le pré-imprégné 54 est remplacé par une couche isolante métallisée 130 formée de la couche de métallisation 22 et d'une couche isolante 132. Les couches isolantes métallisées 130 et 124 sont assemblées l'une avec l'autre grâce à un pré-imprégné 134 recouvrant toute la face supérieure de la couche isolante 126.

La fabrication de ce mode de réalisation du circuit imprimé 6 est identique à celle décrite en regard de la figure 5 sauf que lors de l'étape 90 d'assemblage, le pré-imprégné 134 est introduit entre les couches isolantes 124 et 130 pour réaliser le collage de ces couches isolantes métallisées.

La figure 12 représente un autre mode de réalisation du circuit imprimé 6 identique à celui décrit en référence à la figure 6 sauf que dans ce mode de réalisation le capot 76 est remplacé par un capot 140. Le capot 140 est réalisé dans un matériau mou c'est-à-dire dont le module de Young est inférieur à 0,1 GPa.

Dans ce mode de réalisation, l'insertion du capot sur l'anneau magnétique 10 consiste à couler le matériau mou dans la cavité 28 sur l'anneau 10. Lorsqu'il est coulé, la viscosité de ce matériau est suffisamment faible pour que celui-ci remplisse entièrement les jeux i et j sans exercer de contrainte mécanique sur l'anneau 10. Typiquement, le matériau utilisé pour réaliser le capot 140 est une résine souple non thermodurcissable. La résine choisie est également apte à résister aux températures de fabrication du circuit imprimé. Par exemple, la résine est du silicone. La rigidité de ce matériau 140 est suffisamment faible pour qu'il n'exerce pas de contrainte mécanique sur l'anneau magnétique 10 et qu'il ne forme pas avec celui-ci un composite à dilatation thermique anisotrope susceptible de déformer l'anneau 10 en réponse à des variations de température. Une fois le capot 140 coulé dans la cavité 28, le reste des étapes de fabrication sont identiques à celles décrites en référence à la figure 5.

La figure 13 représente un mode de réalisation du circuit imprimé 6 identique à celui de la figure 6 sauf que le capot 100 est omis. Le pré-imprégné métallisé 54 est remplacé par un pré-imprégné métallisé 150. Le pré-imprégné métallisé 150 est identique au pré-imprégné 54 sauf que le pré-imprégné 60 est remplacé par un pré-imprégné 152. Le pré-imprégné 152 présente une viscosité à la température de transition vitreuse au moins dix fois et, de préférence, vingt fois supérieure à la viscosité du pré-imprégné 60 lorsqu'elle est mesurée dans les mêmes conditions. Par exemple, le pré-imprégné 152 comporte uniquement une résine thermodurcissable dont la viscosité est supérieure à 10000 Pa.s et, de préférence, supérieure à 20000 Pa.s à la température de transition vitreuse lorsque sa température est élevée conformément aux spécifications du fabricant. Par exemple, la température est élevée de 5°C/minute. La viscosité d'un pré-imprégné peut aussi être mesurée en « mils » ou en millimètre. Pour cela, un trou de diamètre 1 pouce (0,03 mètre) est creusé dans le pré-imprégné. Ensuite, on procède à l'assemblage de couches isolantes avec ce pré-imprégné dans les mêmes conditions que celles qui sont mises en oeuvre lors de l'étape 90. Lors de l'assemblage, le pré-imprégné flue et vient réduire le diamètre du trou. La différence entre le diamètre du trou avant assemblage et le diamètre moyen du trou après assemblage constitue une mesure de la viscosité du pré-imprégné. Cette différence est exprimée en « mil » (2,54*10$^{-5}$ mètre) ou en millimètres. La viscosité du pré-imprégné 152 mesurée selon cette méthode est typiquement inférieure à 3,5 mm et, de préférence, inférieure à 2mm ou 1,5mm. Par exemple, le pré-imprégné 152 est l'un de la famille de référence 37N vendue par la société Arlon®. Par exemple, il s'agit de celui portant la référence 37N0666.

Un tel pré-imprégné est connu sous le terme de « pré-imprégné no-flow ». Le pré-imprégné 152 forme les moyens anti-fluage. En effet, étant donné la très forte viscosité de ce pré-imprégné même lors de l'assemblage, celui-ci ne s'écoule pas jusqu'à l'anneau magnétique 10 même en absence de capot.

La fabrication de ce mode de réalisation est identique à celle décrite en référence à la figure 5 sauf que la fabrication du capot et le dépôt de ce capot peuvent être omis.

La figure 14 représente un mode de réalisation du circuit imprimé 6 identique à celui décrit en référence à la figure 11 sauf que le pré-imprégné 134 est remplacé par un pré-imprégné 160. Le pré-imprégné 160 est un pré-imprégné no-flow par exemple identique au pré-imprégné 152. Dans ces conditions, le capot 76 peut être omis puisque la forte viscosité de ce pré-imprégné 160 lors de l'assemblage l'empêche de s'écouler jusqu'à l'anneau 10.

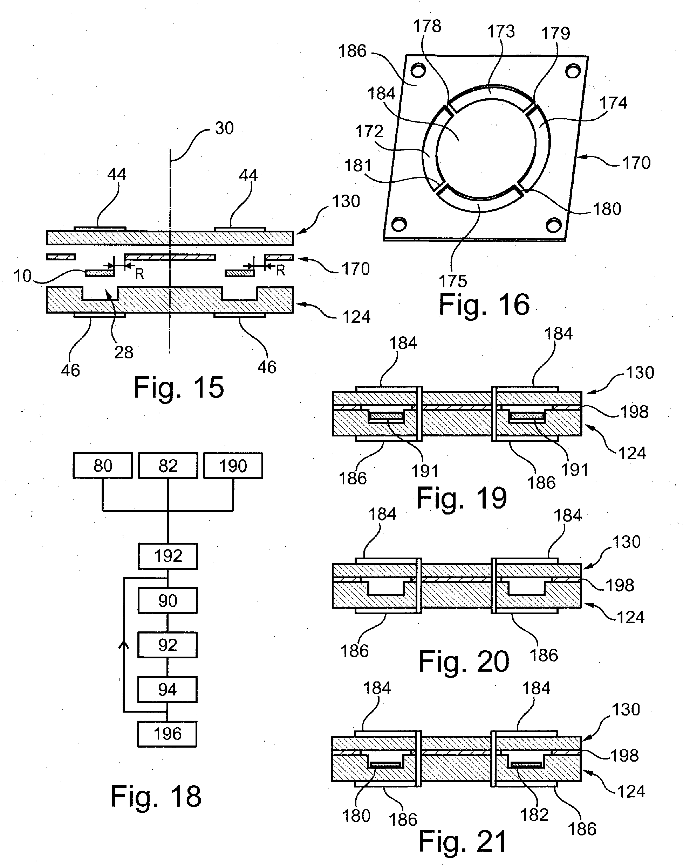

Le mode de réalisation de la figure 15 est identique au mode de réalisation de la figure 11 sauf que le capot 76 et les épaulements sont omis et que le pré-imprégné 134 est remplacé par un pré-imprégné 170. Le pré-imprégné 170 est représenté plus en détail sur la figure 16. Le pré-imprégné 170 est identique au pré-imprégné 134 sauf qu'il comporte des ouvertures réalisées de manière à se trouver en vis-à-vis de la bouche de la cavité 28 lors de l'assemblage. Par exemple, ici, il comporte quatre ouvertures 172 à 175, chacune en forme de portion d'anneau, et centrées sur l'axe de révolution 30.

La largeur transversale de chacune de ces ouvertures est égale à la largeur de la bouche de la cavité 28 dans la face supérieure 66 à laquelle est ajoutée une marge de retrait. La marge de retrait est tel que le pré-imprégné 170 ne s'étend pas jusqu'aux lèvres de la bouche de la cavité 28 lors de l'assemblage. Ainsi, avant l'assemblage, les bords des ouvertures 172 à 175 sont en retrait, le long d'une direction radiale, par rapport aux lèvres de la bouche de la cavité 28 d'une distance R. La distance R est déterminée, par exemple expérimentalement, pour que pendant l'assemblage, le pré-imprégné 170 ne puisse pas s'écouler jusqu'à l'anneau magnétique 10. La distance R est par exemple supérieure ou égale à $100\mu m$ et, de préférence, supérieure ou égale à $200\mu m$ ou $300\mu m$ ou 1mm. Ainsi, ces ouvertures 172 à 175 forment des moyens anti-fluage.

Le pré-imprégné 170 comprend également des ponts 178 à 181 répartis à intervalles réguliers autour de l'axe 30 pour relier mécaniquement un noyau central 184 du pré-imprégné 170 à la périphérie 186 du pré-imprégné 170. La largeur de ces ponts 178 à 181 est choisie de manière que leur surface cumulée soit inférieure à 20 % et, de préférence, inférieure à 10 ou 5 % de la surface de la face supérieure de l'anneau 10.

Dans ces conditions, même si ces ponts sont amenés, lors de l'assemblage, à fluer jusqu'à l'anneau magnétique 10, la surface recouverte de l'anneau 10 est suffisamment faible pour ne pas créer de contraintes mécaniques susceptibles de perturber de façon importante le fonctionnement du capteur 2.

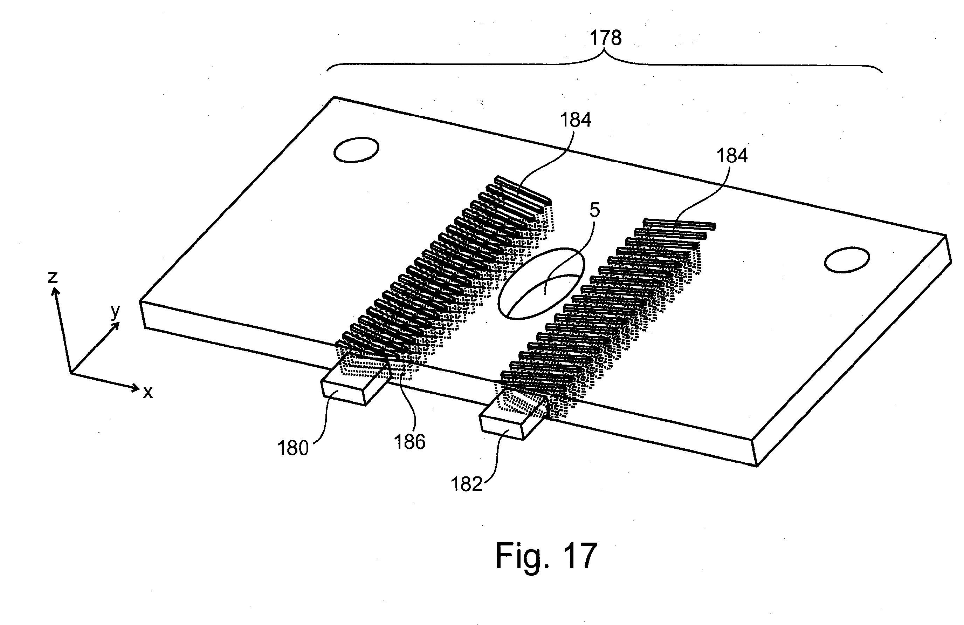

La figure 17 représente un circuit imprimé 178 utilisable à la place du circuit 6. Ce circuit 178 est identique au circuit imprimé 6 sauf que l'anneau magnétique 10 est remplacé par deux barreaux magnétiques 180 et 182. Il comprend donc des moyens anti-fluage tels que décrits précédemment. Ces barreaux magnétiques sont parallélépipédiques et disposés parallèlement l'un à l'autre dans la direction Y. Pour clarifier la figure 17, ils ont été représentés comme faisant saillie au-delà du circuit 178 mais dans la réalité ils sont entièrement logés à l'intérieur de ce circuit. Par exemple, l'épaisseur et la largeur de ces barreaux 180 et 182 sont identiques à celles de l'anneau 10. La longueur des barreaux 180 et 182 dans la direction Y est typiquement comprise entre 5 et 60 mm. Une bobine d'excitation et une bobine de mesure sont enroulées autour de chacun de ces barreaux 180, 182. Ces bobines sont réalisées comme décrit pour le circuit imprimé 6. Les pistes conductrices supérieures et inférieures des bobines d'excitations portent les références, respectivement, 184 et 186 sur la figure 17. Les bobines de mesures et l'unité 18 de traitement ne sont pas représentées pour simplifier l'illustration.

Le fonctionnement d'un capteur de courant réalisé à l'aide du circuit imprimé 178 est similaire à celui du capteur 2. Toutefois, l'utilisation de barreaux plutôt que d'un anneau permet de mesurer un courant de plus forte intensité tout en conservant un encombrement réduit.

La figure 18 représente un procédé de fabrication du circuit imprimé 178.

Ce procédé de fabrication est identique à celui décrit en référence à la figure 5 sauf que l'anneau magnétique 10 est remplacé par deux barreaux magnétiques et qu'une cale temporaire est utilisée lors de l'assemblage.

Plus précisément, l'étape 84 est remplacée par une étape 190 de fabrication de deux cales temporaires 191 (figure 19) ayant des dimensions supérieures ou égales à celle des barreaux magnétiques 180 et 182 et strictement inférieures à la dimension de la cavité 28 dans laquelle sont reçus ces barreaux.

L'étape 86 est remplacée par une étape 192 lors de laquelle les cales temporaires sont insérées dans chacune des cavités à la place des barreaux magnétiques 180, 182.

Ensuite, on procède aux étapes 90, 92 et 94. Ces étapes 90, 92 et 94 peuvent être réitérées pour empiler plus de deux couches de métallisation.

A l'issue de l'étape 94, lors d'une étape 196, on procède au remplacement des cales temporaires 191 par les noyaux magnétiques 180 et 182. Pour cela, on découpe une extrémité du circuit imprimé 178 pour mettre à jour les extrémités des cavités dans lesquelles sont logées les cales temporaires 191. On obtient alors l'état représenté sur la figure 19. Ensuite, les cales temporaires 191 sont retirées par ces extrémités mises à jour. On obtient alors l'état représenté sur la figure 20. Puis les noyaux magnétiques 180 et 182 sont insérés à l'intérieur de leurs cavités respectives par l'intermédiaire de ces mêmes extrémités (figure 21).

Les figures 19 à 21 ont été représentées dans le cas particulier où les moyens anti-fluage sont réalisés comme décrit en référence à la figure 16. Ces moyens sont donc ici un pré-imprégné 198 ajouré dans lequel sont aménagées des ouvertures en vis-à-vis de la cavité pour empêcher l'écoulement de ce pré-imprégné jusqu'au noyau magnétique.

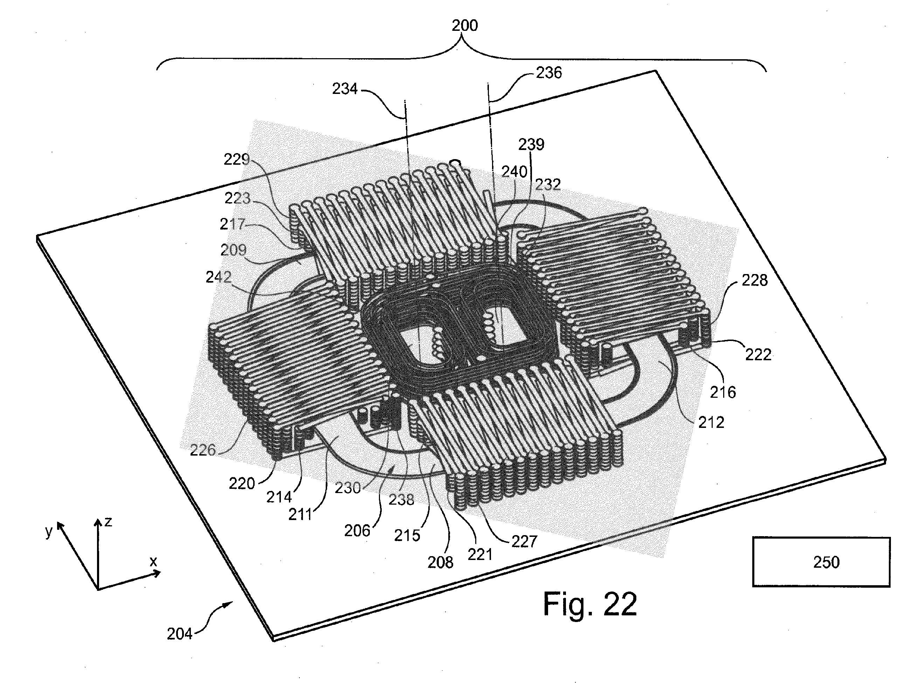

La figure 22 représente un capteur 200 de champ magnétique. Le capteur 200 est un capteur précis de champ magnétique c'est-à-dire que la racine de la moyenne des carrés de la densité spectrale de puissance du bruit (également connue sous l'acronyme RMS PSD) est inférieure à $1\text{nT}/\sqrt{Hz}$ ou $100\,\text{pT}/\sqrt{Hz}$ et, dans certaines configurations, inférieure à $10\,\text{pT}\,\sqrt{Hz}$.

Ici ce capteur 200 est un capteur à vanne de flux plus connu sous le terme anglais de « fluxgate ». Le fonctionnement d'un tel capteur est bien connu et ne sera donc pas décrit en détail. Par exemple, le lecteur peut se référer à la demande de brevet US 7 372 261 pour des explications sur son fonctionnement.

Par la suite, seuls les éléments de ce capteur nécessaires pour comprendre l'invention sont décrits.

Ici, le capteur est utilisé pour mesurer un champ magnétique continu ou statique. Par exemple, ce champ magnétique continu correspond au champ magnétique terrestre.

Le capteur 200 est capable de mesurer l'orientation, et, éventuellement, l'intensité d'un champ magnétique extérieur T. Plus précisément, le capteur 2 mesure les composantes $T_X$, $T_Y$ et $T_Z$ correspondant, respectivement, aux projections du champ magnétique T sur trois directions non colinéaires X, Y et Z. Ici, les directions X, Y et Z sont orthogonales entre elles. La direction Z est la direction verticale et les directions X et Y définissent un plan horizontal.

Le capteur 200 comprend un circuit imprimé 204 multicouche. Typiquement, le circuit imprimé 204 comprend plus de cinq couches de métallisation et, de préférence, plus de dix couches de métallisation. Ici, il comporte dix couches de métallisation. Les couches de métallisation sont empilées les unes au-dessus des autres dans la direction Z. La couche de métallisation la plus en haut dans la direction Z correspond à la face supérieure tandis que la couche de métallisation la plus en bas correspond à la face inférieure du circuit imprimé.

Le circuit imprimé 204 comprend un anneau magnétique 206 logé dans une cavité annulaire horizontale. L'anneau 206 est situé entre les faces supérieure et inférieure du circuit imprimé. Ce circuit imprimé 204 est fabriqué comme décrit précédemment pour le circuit imprimé 6. Il comporte donc notamment l'un des moyens anti-fluage précédemment décrit. Ainsi, seules les principales différences entre ce circuit 204 et le circuit 6 sont soulignées ici.

Ici, l'anneau 206 comprend deux barreaux 208 et 209 parallèles à la direction X et deux barreaux 211 et 212 parallèles à la direction Y. Les extrémités de ces barreaux sont reliées les unes aux autres par un angle en matériau magnétique pour former l'anneau 206.

Pour saturer l'anneau magnétique 206, quatre bobines d'excitation 214 à 217 sont réalisées dans le circuit imprimé 204. Ces bobines d'excitation sont parcourues par un courant d'excitation $i_{0H}$ à une fréquence d'excitation $f_H$. Typiquement, la fréquence d'excitation est supérieure à 300 Hz et de préférence supérieure à 10 kHz. Ici, chacune des bobines 214 à 217 est enroulée autour, respectivement, des barreaux 211, 208, 212 et 209.

Les bobines 214 à 217 sont raccordées en série les unes aux autres de manière à générer un champ magnétique d'excitation $B_{exH}$ de même sens quand elles sont parcourues par le courant $i_{0H}$. Chaque bobine 214 à 217 est formée par des pistes conductrices réalisées dans deux couches de métallisation du circuit imprimé situées, respectivement, au-dessus et en dessous de l'anneau magnétique 206. Les extrémités de ces pistes conductrices sont raccordées entre elles par des vias verticaux pour former les spires des bobines 214 à 217.

Le circuit imprimé 204 comporte également quatre bobines de mesure 220 à 223 enroulées, respectivement, autour des barreaux 211, 208, 212 et 209 pour mesurer le champ magnétique à l'intérieur de ces barreaux. Les mesures du champ magnétique réalisées par chacune de ces bobines 220 à 223 sont notées, respectivement, $M_1$, $M_2$, $M_3$ et $M_4$. Ici, ces mesures sont données par les relations suivantes :

- $M_1 = T_Y - B_{exH}$,
- $M_2 = T_X + B_{exH}$,
- $M_3 = T_Y + B_{exH}$, et
- $M_4 = T_X - B_{exH}$.

Ces relations sont données avec la convention suivante, le champ magnétique d'excitation $B_{ex}$ tourne dans le sens antihoraire et les composantes $T_X$ et $T_Y$ sont dirigées dans la même direction que les directions X, Y respectivement.

Ici, les bobines 220 à 223 sont enroulées autour des bobines d'excitation, respectivement, 214 à 217. Ces bobines 220 à 223 sont formées par des pistes conductrices réalisées dans des couches de métallisation situées au-dessus et en dessous de celles utilisées pour réaliser les pistes conductrices des bobines d'excitation.

Dans ce mode de réalisation, quatre bobines de compensation 226 à 229 sont également enroulées, respectivement, autour des bobines de mesure 220 à 223. Ces bobines 226 à 229 permettent d'annuler le champ magnétique dans les barreaux, respectivement, 211, 208, 212 et 209. Dans ces conditions, la mesure des composantes $T_X$ et $T_Y$ se déduit de l'intensité du courant $i_{cH}$ de compensation qui circule dans ces bobines 226 à 229.

Ces bobines 226 à 229 sont formées par des pistes conductrices réalisées dans des couches de métallisation situées au-dessus et en dessous de celles utilisées pour former les pistes conductrices des bobines de mesure.

Du fait que l'on travaille ici en champ magnétique nul, cela diminue le couplage magnétique entre les mesures réalisées selon les directions X et Y que pourrait provoquer autrement le fait d'utiliser des bobines de mesure qui sont enroulées autour du même anneau magnétique 206.

Le circuit imprimé 204 comprend aussi des bobines verticales pour mesurer la composante $T_Z$. Par bobine verticale, on désigne des bobines qui s'enroulent et s'étend le long d'un axe vertical.

Plus précisément, deux trous 230 et 232 traversant de part en part le circuit imprimé le long, respectivement, d'axes verticaux 234 et 236 sont creusés dans ce circuit imprimé. Ces trous 230 et 232 sont destinés à recevoir chacun une branche respective d'un anneau magnétique vertical. Cet anneau magnétique vertical n'a pas été représenté sur la figure 22 pour simplifier l'illustration.

Autour de ces trous 230 et 232, le circuit imprimé comprend deux bobines 238 et 239 d'excitation propres à générer un champ magnétique d'excitation $B_{exv}$ capable de saturer l'anneau magnétique vertical lorsqu'elles sont parcourues par un courant d'excitation $i_{exv}$ de fréquence $f_{exv}$. Par exemple, le courant $i_{exv}$ et la fréquence $f_{exv}$ sont pris égaux, respectivement, au courant $i_{exH}$ et à la fréquence $f_{exH}$.

Une bobine verticale de mesure 240 entoure les deux trous 230 et 232. Cette bobine 240 est destinée à mesurer le champ magnétique dans l'anneau magnétique vertical.

Enfin, une bobine verticale de compensation 242 est également réalisée dans le circuit imprimé 204. Cette bobine entoure les trous 230 et 232. Comme précédemment, cette bobine a pour fonction d'annuler le champ magnétique dans l'anneau magnétique vertical lorsqu'elle est parcourue par un courant $i_{cv}$ de compensation.

Ces bobines 238, 239, 240 et 242 sont formées par des pistes conductrices réalisées dans des couches de métallisation du circuit imprimé 204. Ces pistes conductrices sont raccordées les unes aux autres par l'intermédiaire de vias verticaux pour former les spires de chacune de ces bobines.

Enfin, le capteur 200 comporte une unité électronique 250 de traitement apte à commander l'alimentation des bobines d'excitation et de compensation et à traiter les signaux des bobines de mesure pour obtenir une mesure du champ magnétique T. Typiquement, la mesure de chaque composante du champ magnétique T est obtenue à partir de l'amplitude d'une harmonique de la fréquence d'excitation dans le champ magnétique mesuré par les bobines de mesure.

De nombreux autres modes de réalisation sont possibles. Par exemple, la couche isolante peut être réalisée différemment. Par exemple, elle peut être conforme au standard tel que FR-5, G10 ou G11.

Les vias peuvent aussi être réalisés par des rivets métalliques.

Les pistes conductrices peuvent être réalisées par d'autres technologies que la gravure d'une couche de métallisation. Par exemple, les pistes conductrices peuvent être également déposées sur une couche isolante. Avec cette dernière technologie, la couche de métallisation est la couche dans laquelle sont déposées les pistes conductrices.

Dans le mode de réalisation de la figure 7, l'alésage peut ne pas être traversant.

Les différents modes de réalisation des moyens anti-fluage décrits ici peuvent être combinés entre eux.

L'utilisation d'une cale temporaire peut être mise en oeuvre quels que soient les moyens d'anti-fluage utilisés.

Le procédé de la figure 18 a été décrit dans le cas particulier où l'étape 196 est située après l'étape 94. Toutefois, l'étape 196 peut également être réalisée après l'une des étapes 90, 92 ou 94.

Une même bobine peut remplir à la fois les fonctions de bobine de mesure et de bobine d'excitation. Ceci est rendu possible par le fait que la mesure se fait sur des harmoniques de la fréquence d'excitation. Dans ce cas, les bobines 12 et 13 sont par exemple remplacées par une seule et même bobine. Une même bobine peut aussi remplir les fonctions de bobine de mesure et de compensation.

Les spires des bobines d'excitation et de mesure peuvent être entrelacées comme décrit en référence à la figure 6 de la demande de brevet US 7 372 261.

En variante, les anneaux magnétiques et les bobines de mesure et d'excitation sont réalisés dans le même circuit imprimé. Dans ce cas, il n'est pas nécessaire de superposer deux circuits imprimés réalisés indépendamment l'un de l'autre.

Enfin, dans un mode de réalisation simplifié, l'anneau magnétique 15 et les bobines 16 et 17 sont omises. Dans ce cas, l'unité de traitement 18 est programmée pour compenser le champ magnétique d'excitation présent dans la mesure délivrée par la bobine 13.

L'anneau 10 est conformé pour capter un maximum de flux magnétique généré par le fil conducteur. Par exemple, si le fil 3 est remplacé par un barreau conducteur de section rectangulaire, avantageusement, l'anneau 10 est remplacé par un anneau rectangulaire.

L'anneau magnétique vertical logé dans les trous 230, 232 peut être réalisé à l'aide de deux parties magnétiques en forme de « U » assemblée tête bêche ou en enroulant un fil ou une bande magnétique dans les trous. Dans ce cas, de préférence, la bande ou le fil forme une ou plusieurs spires passant chacune par les trous. L'anneau magnétique peut aussi être remplacé par deux barreaux magnétiques verticaux et parallèles.

Dans le mode de réalisation de la figure 22, on peut aussi superposer plusieurs circuits imprimés multicouches afin d'augmenter le rapport longueur/largeur des anneaux magnétiques, ainsi que le nombre de spires du capteur.

En variante, le fil 3 est formé d'une portion rigide solidaire du circuit imprimé. Typiquement, cette portion rigide du fil 3 est une piste électrique verticale réalisée dans le circuit imprimé. Par exemple, cette piste électrique verticale est réalisée par métallisation du trou 5. Les parties souples du fil 3 sont alors raccordées à cette piste électrique pour réaliser la mesure de l'intensité du courant.

## Revendications

1. Circuit imprimé (6, 7) pour la réalisation d'un capteur de courant dans un fil conducteur, ce circuit imprimé comportant :

   - un empilement, le long d'une direction verticale, de plusieurs couches de métallisation séparées mécaniquement les unes des autres par des couches électriquement isolantes,
   - un noyau magnétique,
   - une ou plusieurs premières bobines (12, 13) remplissant les fonctions de bobine de mesure et de bobine d'excitation, chaque première bobine étant pourvue de spires uniquement enroulées autour du noyau magnétique,

   **caractérisé en ce que** :

   - le circuit imprimé comporte un trou (5) le traversant de part en part le long d'un axe vertical pour recevoir le fil conducteur,
- le noyau magnétique forme un premier anneau magnétique (10) entourant le trou et s'étendant horizontalement entre des couches de métallisation, et
- chaque spire de chaque première bobine est formée par deux pistes conductrices (44, 46) réalisées, respectivement, dans des couches de métallisation situées au-dessus et en-dessous du premier anneau magnétique et raccordées électriquement l'une à l'autre par un plot (48) traversant une couche isolante et passant par l'intérieur, de cet anneau magnétique.

2. Capteur de courant dans un fil conducteur, ce capteur comportant :

- un circuit imprimé selon la revendication 1, et
- une source (19) de courant d'excitation propre à faire circuler dans la bobine d'excitation un courant dont l'intensité provoque une saturation périodique du noyau magnétique.

3. Capteur selon la revendication 2 ou circuit selon la revendication 1, dans lequel le circuit imprimé comprend :

- une cavité annulaire (28) à l'intérieur de laquelle est logé l'anneau magnétique, et
- les dimensions transversales, c'est-à-dire dans un plan vertical, de l'anneau magnétique sont inférieures d'au moins 5 $\mu$m aux dimensions transversales correspondantes de la cavité de manière à ménager un jeu entre les parois de cette cavité et les faces en vis-à-vis de l'anneau magnétique.

4. Capteur selon la revendication 2 ou circuit selon la revendication 1, dans lequel le capteur ou le circuit comporte :

- au moins un second anneau magnétique (15) entourant le même trou et s'étendant horizontalement entre des couches de métallisation,
- une ou plusieurs secondes bobines (16, 17) remplissant les fonctions de bobine de mesure et de bobine d'excitation, chaque seconde bobine étant pourvue de spires uniquement enroulées autour du second anneau magnétique, chaque spire de chaque seconde bobine étant formée par deux pistes conductrices réalisées, respectivement, dans les couches de métallisation situées au-dessus et en-dessous du second anneau magnétique et raccordées électriquement l'une à l'autre par un plot traversant une couche isolante et passant par l'intérieur de ce second anneau magnétique, et
- les première et seconde bobines (13, 17) de mesure sont raccordées en série de manière à diminuer la contribution du champ magnétique d'excitation dans le courant généré par ces bobines de mesure.

5. Capteur ou circuit selon la revendication 4, dans lequel la première et la seconde bobines (12, 16) d'excitation sont agencées de manière à générer un champ magnétique d'excitation à l'intérieur, respectivement, des premier et second anneaux magnétiques (10, 15) de même intensité lorsqu'elles sont alimentées par le même courant d'excitation, et les première et seconde bobines (13, 17) de mesure sont agencées de manière à mesurer le même champ magnétique, respectivement, dans les premier et second anneaux en absence de champ magnétique d'excitation.

6. Capteur ou circuit selon la revendication 5, dans lequel :

- les première et seconde bobines (12, 16) d'excitation sont identiques sauf qu'elles sont enroulées, respectivement, autour des premier et second anneaux magnétiques, et
- les première et seconde bobines (13, 17) de mesure sont identiques sauf qu'elles sont enroulées, respectivement, autour des premier et second anneaux magnétiques.

**Patentansprüche**

1. Leiterplatte (6, 7) zur Herstellung eines Stromsensors in einem Leitungsdraht, wobei diese Leiterplatte aufweist:

- eine Stapelung, entlang einer senkrechten Richtung, von mehreren durch elektrisch isolierende Schichten mechanisch voneinander getrennten Metallisierungsschichten,
- einen Magnetkern,
- eine oder mehrere erste Spulen (12, 13), die die Funktionen einer Messspule und einer Erregerspule erfüllen, wobei jede erste Spule mit Windungen versehen ist, die nur um den Magnetkern gewickelt sind,

**dadurch gekennzeichnet, dass**:

- die Leiterplatte ein Loch (5) aufweist, das sie entlang einer senkrechten Achse von einer Seite zur anderen durchquert, um den Leitungsdraht aufzunehmen,
- der Magnetkern einen ersten Magnetring (10) bildet, der das Loch umgibt und sich waagrecht zwischen Metallisierungsschichten erstreckt, und

- jede Windung jeder ersten Spule von zwei Leiterbahnen (44, 46) gebildet wird, die in Metallisierungsschichten ausgebildet sind, welche sich über bzw. unter dem ersten Magnetring befinden, und durch einen Anschlusskontakt (48) elektrisch miteinander verbunden sind, der eine Isolierschicht durchquert und durch das Innere dieses Magnetrings geht.

2. Stromsensor in einem Leitungsdraht, wobei dieser Sensor aufweist:

- eine Leiterplatte nach Anspruch 1 und
- eine Erregerstromquelle (19), die in der Erregerspule einen Strom fließen lassen kann, dessen Stärke eine periodische Sättigung des Magnetkerns bewirkt.

3. Sensor nach Anspruch 2 oder Leiterplatte nach Anspruch 1, wobei die Leiterplatte enthält:

- einen ringförmigen Hohlraum (28), in dessen Innerem der Magnetring untergebracht ist, und
- die Querabmessungen, d.h. in einer senkrechten Ebene, des Magnetrings um mindestens 5 $\mu$m kleiner sind als die entsprechenden Querabmessungen des Hohlraums, um ein Spiel zwischen den Wänden dieses Hohlraums und den gegenüberliegenden Seiten des Magnetrings frei zu lassen.

4. Sensor nach Anspruch 2 oder Leiterplatte nach Anspruch 1, wobei der Sensor oder die Leiterplatte enthält:

- mindestens einen zweiten Magnetring (15), der das gleiche Loch umgibt und sich waagrecht zwischen Metallisierungsschichten erstreckt,
- eine oder mehrere zweite Spulen (16, 17), die Funktionen einer Messspule und einer Erregerspule erfüllen, wobei jede zweite Spule mit Windungen versehen ist, die nur um den zweiten Magnetring gewickelt sind, wobei jede Windung jeder zweiten Spule von zwei Leiterbahnen gebildet wird, die in den Metallisierungsschichten ausgebildet sind, die sich über bzw. unter dem zweiten Magnetring befinden, und durch einen Kontaktanschluss elektrisch miteinander verbunden sind, der eine Isolierschicht durchquert und durch das Innere dieses zweiten Magnetrings geht, und
- die erste und die zweite Messspule (13, 17) in Reihe geschaltet sind, um den Beitrag des Erregermagnetfelds zum von den Messspulen erzeugten Strom zu verringern.

5. Sensor oder Leiterplatte nach Anspruch 4, wobei die erste und die zweite Erregerspule (12, 16) angeordnet sind, um ein Erregermagnetfeld im Inneren des ersten bzw. zweiten Magnetrings (10, 15) von gleicher Stärke zu erzeugen, wenn sie mit dem gleichen Erregerstrom gespeist werden, und die erste und die zweite Messspule (13, 17) eingerichtet sind, um das gleiche Magnetfeld im ersten und zweiten Ring in Abwesenheit eines Erregermagnetfelds zu messen.

6. Sensor oder Leiterplatte nach Anspruch 5, wobei:

- die erste und die zweite Erregerspule (12, 16) gleich sind, abgesehen davon, dass sie um einen ersten bzw. zweiten Magnetring gewickelt sind, und
- die erste und die zweite Messspule (13, 17) gleich sind, abgesehen davon, dass sie um einen ersten bzw. zweiten Magnetring gewickelt sind.

**Claims**

1. A printed circuit (6, 7) for producing a sensor of current in a conducting wire, this printed circuit comprising:

- a stack, along a vertical direction, of several metallization layers separated mechanically from one another by electrically insulating layers,
- a magnetic core,
- one or more first coils (12, 13) fulfilling the functions of measurement coil and of excitation coil, each first coil being provided with turns wound solely around the magnetic core,

**characterized in that**:

- the printed circuit comprises a hole (5) passing right through it along a vertical axis to receive the conducting wire,
- the magnetic core forms a first magnetic annulus (10) surrounding the hole and extending horizontally between metallization layers, and
- each turn of each first coil is formed by two conducting tracks (44, 46) produced, respectively, in metallization layers situated above and below the first magnetic annulus and linked electrically to one another by a pad (48) passing through an insulating layer and passing through the interior of this magnetic annulus.

2. A sensor of current in a conducting wire, this sensor comprising:

- a printed circuit (6, 7) according to Claim 1, and
- a source (19) of excitation current suitable for causing the flow in the excitation coil of a current whose intensity causes a periodic saturation of the magnetic core.

3. Sensor according to Claim 2 or circuit according to Claim 1, in which the printed circuit comprises:

- an annular cavity (28) inside which is housed the magnetic annulus, and
- the transverse dimensions, that is to say in a vertical plane, of the magnetic annulus are at least 5 μm smaller than the corresponding transverse dimensions of the cavity so as to leave a clearance between the walls of this cavity and the faces opposite of the magnetic annulus.

4. Sensor according to Claim 2 or circuit according to Claim 1, in which the sensor or the circuit comprises:

- at least one second magnetic annulus (15) surrounding the same hole and extending horizontally between metallization layers,
- one or more second coils (16, 17) fulfilling the functions of measurement coil and of excitation coil, each second coil being provided with turns wound solely around the second magnetic annulus, each turn of each second coil being formed by two conducting tracks produced, respectively, in the metallization layers situated above and below the second magnetic annulus and linked electrically to one another by a pad passing through an insulating layer and passing through the interior of this second magnetic annulus, and
- the first and second measurement coils (13, 17) are linked in series so as to decrease the contribution of the magnetic excitation field in the current generated by these measurement coils.

5. Sensor or circuit according to Claim 4, in which the first and the second excitation coils (12, 16) are arranged so as to generate a magnetic excitation field in the interior, respectively, of the first and second magnetic annuli (10, 15) of the same intensity when they are supplied by the same excitation current, and the first and second measurement coils (13, 17) are arranged so as to measure the same magnetic field, respectively, in the first and second annuli in the absence of magnetic excitation field.

6. Sensor or circuit according to Claim 5, in which:

- the first and second excitation coils (12, 16) are identical except that they are wound, respectively, around the first and second magnetic annuli, and
- the first and second measurement coils (13, 17) are identical except that they are wound, respectively, around the first and second magnetic annuli.

Fig. 1

Fig. 2

Fig. 2A

Fig. 3

Fig. 4

Fig. 5

Fig. 6

Fig. 7

Fig. 8

Fig. 9

Fig. 10

Fig. 11

Fig. 12

Fig. 13

Fig. 14

**Fig. 15**

**Fig. 16**

**Fig. 18**

**Fig. 19**

**Fig. 20**

**Fig. 21**

Fig. 17

EP 2 754 338 B1

Fig. 22

EP 2 754 338 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2108965 A1
- US 2003011458 A1
- DE 10354694 A1
- US 2011108317 A1
- US 2002070831 A1
- WO 0225797 A2
- US 7372261 B

**Littérature non-brevet citée dans la description**

- **T. O'DONNELL ; A. TIPEK ; A. CONNELL ; P. MC CLOSKEY ; S. C. O'MATHUNA.** Planar fluxgate current sensor integrated in printed circuit board. *Sensors and Actuators A,* 2006, vol. 129, 20-24